# EUROPEAN PATENT APPLICATION

(11) **EP 4 738 424 A1**
(43) Date of publication of application: **06.05.2026**
(21) Application number: 24831576.4
(22) Date of filing: 04.06.2024
(51) Int. Cl.: H01L 21/02, G05B 23/02

(54) **WORK ASSISTANCE METHOD AND WORK ASSISTANCE SYSTEM**

(30) Priority: 27.06.2023 JP 2023104668
(71) Applicant: SCREEN Holdings Co., Ltd., Kyoto-shi, Kyoto 602-8585 (JP)
(72) Inventor: SHIMIZU Shinji, Kyoto-shi, Kyoto 602-8585 (JP); TAKAHASHI Mitsukazu, Kyoto-shi, Kyoto 602-8585 (JP)
(74) Representative: Kilian Kilian & Partner mbB
(86) International application number: PCT/JP2024/020289
(87) International publication number: WO 2025/004706

(57) **Abstract**

Information regarding an apparatus state of a substrate processing apparatus is collected, and whether an operation with respect to a portion in the apparatus is possible is determined based on the state information. When it is dangerous to perform an operation with respect to the portion, it is determined that the portion cannot be operated. A display unit of smart glasses performs coloring display based on the determination result with respect to a portion (visually recognizable portion) that can be seen by the operator among the determined portions. On the other hand, coloring display is not performed with respect to the portion that cannot be seen by the operator. The operator can easily and clearly recognize whether the portion to be worked can be operated regardless of the situation of the portion that cannot be seen.

## Description

### TECHNICAL FIELD

The present invention relates to a work assistance method and a work assistance system used when predetermined work such as maintenance work is performed on industrial equipment such as a substrate processing apparatus that performs predetermined processing on a substrate. Substrates to be processed by the substrate processing apparatus include, for example, a semiconductor substrate, a substrate for a liquid crystal display apparatus, a substrate for a flat panel display (FPD), a substrate for an optical disk, a substrate for a magnetic disk, or a substrate for a solar cell.

### BACKGROUND ART

Conventionally, in a semiconductor device manufacturing process, a substrate processing apparatus that performs various types of processing on a substrate such as a semiconductor substrate is used. As the substrate processing apparatus, for example, a substrate cleaning apparatus, a heat treatment apparatus, an inspection apparatus, and the like are used. Typically, a large number of substrate processing apparatuses are disposed orderly in a wide clean room in many cases. Maintenance is performed on these substrate processing apparatuses at an appropriate timing. Patent Document 1 describes that a large number of substrate processing apparatuses are arranged at a relatively high density in a clean room and maintenance of the substrate processing apparatuses is performed.

### PRIOR ART DOCUMENT

### PATENT DOCUMENT

Patent Document 1: Japanese Patent Application Laid-Open No. 2020-4866

### SUMMARY

### PROBLEM TO BE SOLVED BY THE INVENTION

When maintenance of the substrate processing apparatus is performed, an operator may open a cover of a chamber or perform construction on a pipe. However, the inside of the chamber may be in a dangerous state. For example, when the inside of the chamber is purged with nitrogen gas, the inside of the chamber is in a dangerous state in which oxygen is hardly present. In addition, immediately after a chemical liquid such as hydrofluoric acid is used, there is a possibility that the chamber is filled with vapor of the chemical liquid, or droplets of the chemical liquid are attached. Further, the residual pressure in the pipe routed to the chamber may be high.

When the inside of the chamber is in a dangerous state as described above, the operator opening the cover may lead to an accident. Thus, when the inside of the chamber is in a dangerous state, the cover should not be opened. However, the dangerous state as described above is not visible to human eyes, and it is difficult for the operator to determine whether to open the cover.

The present invention has been made in view of the above-described problem, and an object of the present invention is to provide a work assistance method and a work assistance system that allow an operator to easily recognize whether a portion to be worked can be operated.

### MEANS TO SOLVE THE PROBLEM

To solve the above-described problem, a first aspect of the present invention is a work assistance method used when predetermined work is performed on industrial equipment, the work assistance method including an information acquisition step of collecting state information regarding an apparatus state of the industrial equipment, a determination step of determining whether operation with respect to a visually recognizable portion of the industrial equipment is possible based on the state information, and a display step of performing annotation display with respect to the visually recognizable portion based on a determination result in the determination step with a mobile terminal including a display unit and a communication unit.

In a second aspect, in the work assistance method according to the first aspect, in the display step, the mobile terminal performs coloring display in a first display color with respect to the visually recognizable portion determined to be inoperable in the determination step.

In a third aspect, in the work assistance method according to the second aspect, in the display step, the mobile terminal performs coloring display in a second display color with respect to the visually recognizable portion determined to be operable in the determination step.

In a fourth aspect, in the work assistance method according to the third aspect, the industrial equipment is a substrate processing apparatus that performs predetermined processing on a substrate, a processing chamber included in the substrate processing apparatus is provided with an inner cover and an outer cover, and in the display step, when an inside of the processing chamber is in a dangerous state, coloring display is performed in the second display color with respect to the outer cover when the inner cover and the outer cover are closed, and coloring display is performed in the first display color with respect to the inner cover when the outer cover is opened.

In a fifth aspect, in the work assistance method according to the fourth aspect, the substrate processing apparatus is a substrate cleaning apparatus that uses a processing gas and a processing liquid in the processing chamber.

In a sixth aspect, in the work assistance method according to any one of the first to fifth aspects, the mobile terminal is smart glasses.

A seventh aspect is a work assistance system used when predetermined work is performed on industrial equipment, the work assistance system including a mobile terminal including a display unit and a communication unit and a determination unit that determines whether an operation with respect to a visually recognizable portion of the industrial equipment is possible based on state information regarding an apparatus state of the industrial equipment, wherein the display unit performs annotation display with respect to the visually recognizable portion based on a determination result determined by the determination unit.

In an eighth aspect, in the work assistance system according to the seventh aspect, the display unit performs coloring display in a first display color with respect to the visually recognizable portion determined to be inoperable by the determination unit.

In a ninth aspect, in the work assistance system according to the eighth aspect, the display unit performs coloring display in a second display color with respect to the visually recognizable portion determined to be operable by the determination unit.

In a tenth aspect, in the work assistance system according to the ninth aspect, the industrial equipment is a substrate processing apparatus that performs predetermined processing on a substrate, a processing chamber included in the substrate processing apparatus is provided with an inner cover and an outer cover, and when an inside of the processing chamber is in a dangerous state, the display unit performs coloring display in the second display color with respect to the outer cover when the inner cover and the outer cover are closed, and performs coloring display in the first display color with respect to the inner cover when the outer cover is opened.

In an eleventh aspect, in the work assistance system according to the tenth aspect, the substrate processing apparatus is a substrate cleaning apparatus that uses a processing gas and a processing liquid in the processing chamber.

In a twelfth aspect, in the work assistance system according to any one of the seventh to eleventh aspects, the mobile terminal is smart glasses.

### EFFECTS OF THE INVENTION

According to the work assistance method according to the first to sixth aspects, it is determined whether the operation with respect to the visually recognizable portion of the industrial equipment is possible based on the state information that has been collected, and the annotation display is performed with respect to the visually recognizable portion based on the determination result. Thus, the operator can easily recognize whether the operation with respect to the portion to be worked is possible regardless of the situation of the portion that cannot be seen.

According to the work assistance system according to the seventh to twelfth aspects, it is determined whether the operation with respect to the visually recognizable portion of the industrial equipment is possible based on the state information that has been collected, and the annotation display is performed with respect to the visually recognizable portion based on the determination result. Thus, the operator can easily recognize whether the operation with respect to the portion to be worked is possible regardless of the situation of the portion that cannot be seen.

### BRIEF DESCRIPTION OF DRAWINGS

[FIG. 1] is a diagram schematically illustrating a schematic configuration of a work assistance system according to the present invention.
[FIG. 2] is a plan view illustrating an example of a layout of a plurality of substrate processing apparatuses.
[FIG. 3] is a diagram illustrating a configuration of one substrate processing apparatus.
[FIG. 4] is a diagram illustrating a schematic configuration of a processing unit.
[FIG. 5] is a perspective view illustrating an appearance of smart glasses.
[FIG. 6] is a block diagram illustrating a functional configuration of the smart glasses, a server, a work assistance terminal, and a control unit of the substrate processing apparatus.
[FIG. 7] is a flowchart illustrating a procedure of a work assistance method according to the present invention.
[FIG. 8] is a diagram illustrating an example of a spatial mesh.
[FIG. 9] is a diagram schematically illustrating a relative positional relationship between a reference position and a portion of the substrate processing apparatus.
[FIG. 10] is a diagram illustrating an example of coloring display with respect to an outer cover.
[FIG. 11] is a diagram illustrating an example of coloring display with respect to an inner cover when the outer cover is opened.

### DESCRIPTION OF EMBODIMENT

Hereinafter, an embodiment of the present invention will be described in detail with reference to the drawings. In the following, unless otherwise specified, an expression (for example, "in one direction", "along one direction", "parallel", "orthogonal", "central", "concentric", or "coaxial") indicating a relative or absolute positional relationship not only strictly represents the positional relationship, but also indicates a state of being displaced relatively with respect to an angle or a distance within a range of a tolerance or a range in which a similar function can be obtained. In addition, unless otherwise specified, an expression (for example, "identical", "equal", or "homogeneous") indicating an equal state not only represents a quantitatively strictly equal state, but also represents a state in which there is a tolerance or a difference with which a similar function can be obtained. In addition, unless otherwise specified, an expression (for example, "circular shape", "quadrangular shape", or "cylindrical shape") indicating a shape not only represents the shape geometrically and strictly, but also represents a shape in a range in which the same level of effect can be obtained, and may have, for example, unevenness or chamfering. Each expression such as "comprising", "provided", "including", "containing", or "having" a component is not an exclusive expression excluding the presence of other components. The expression "at least one of A, B, and C" includes "only A", "only B", "only C", "any two of A, B, and C", and "all of A, B and C".

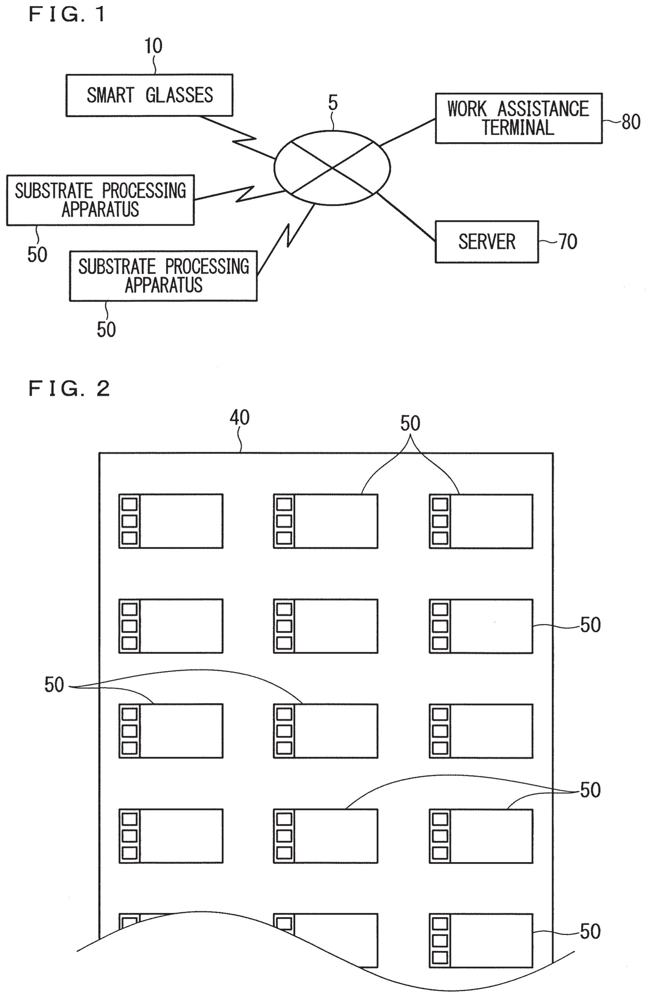

FIG. 1 is a diagram schematically illustrating a schematic configuration of a work assistance system according to the present invention. The work assistance system according to the present invention includes a plurality of substrate processing apparatuses 50, smart glasses 10, a server 70, and a work assistance terminal 80. The smart glasses 10 and the controller of the substrate processing apparatus 50 are connected to an information communication network 5. (for example, the Internet) through wireless communication. The work assistance terminal 80 and the server 70 are connected to the information communication network 5 in a wired manner. Information can be exchanged between devices connected to the information communication network 5, and for example, information can be exchanged between the smart glasses 10 and the work assistance terminal 80. Whether to connect each device and the information communication network 5 in a wireless manner or wired manner is not limited to the example described above, and an appropriate form can be adopted (for example, the work assistance terminal 80 and the information communication network 5 may be wirelessly connected).

FIG. 2 is a plan view illustrating an example of a layout of the plurality of substrate processing apparatuses 50. As illustrated in FIG. 2, the plurality of substrate processing apparatuses 50 are disposed in an orderly manner at regular intervals in a clean room 40. The clean room 40 is, for example, a room provided in a semiconductor device manufacturing factory, in which a certain degree of air cleanliness is secured, and the temperature and humidity are managed. In the present embodiment, a plurality of substrate processing apparatuses 50 of the same type and the same form are disposed in a relatively wide clean room 40. Thus, it is difficult for an operator to distinguish the substrate processing apparatuses 50 disposed in the clean room 40 only from the appearance.

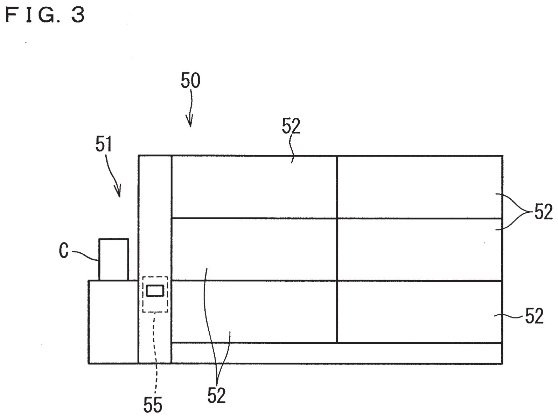

FIG. 3 is a diagram illustrating a configuration of one substrate processing apparatus 50. In the present embodiment, the substrate processing apparatus 50 is, for example, a single wafer type substrate cleaning apparatus that cleans substrates one by one. The substrate processing apparatus 50 includes an indexer 51 and a plurality of processing units 52. A carrier C containing a plurality of substrates is placed on the indexer 51. The indexer 51 takes out an unprocessed substrate from the placed carrier C with an indexer robot (not illustrated). In addition, the indexer 51 stores the substrate processed by the indexer robot in the carrier C. The carrier C is, for example, a front opening unified pod (FOUP) that stores the substrate in a sealed space.

In the present embodiment, for example, three processing units 52 are stacked to form one stacked body. For example, four stacked bodies are disposed around a main conveyance robot (not illustrated). That is, one substrate processing apparatus 50 includes, for example, 12 (= 3 × 4) processing units 52.

The main conveyance robot disposed at the center of the four stacked bodies loads the unprocessed substrate delivered from the indexer robot into any of the 12 processing units 52. In addition, the main conveyance robot unloads the processed substrate from the processing unit 52 and delivers the substrate to the indexer robot.

The substrate processing apparatus 50 includes a control unit 55. The control unit 55 is a general computer, and controls operations of the indexer robot, the main conveyance robot, and each processing unit 52 provided in the apparatus. The control unit 55 includes a touch panel that is an input/output interface provided on a wall surface of the apparatus and a communication unit that communicates with the outside of the apparatus.

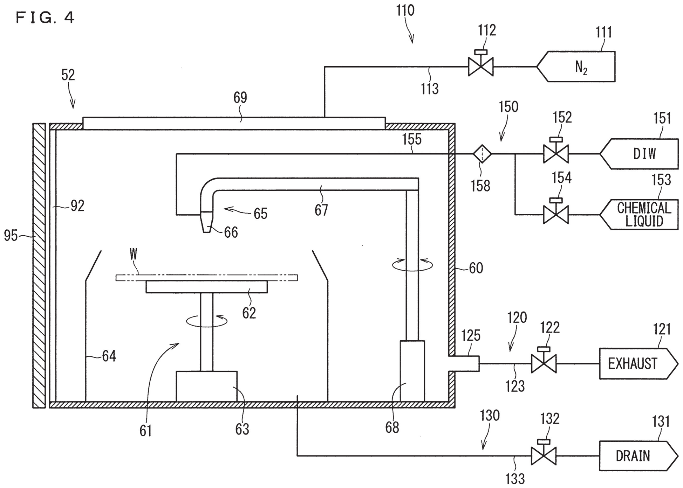

FIG. 4 is a diagram illustrating a schematic configuration of one processing unit 52. The processing unit 52 discharges a processing liquid to one substrate W to perform cleaning processing. The processing liquid is a term of a concept including various chemical liquids and pure water. Examples of the chemical liquid include a liquid for performing etching processing or a liquid for removing particles, and specifically, SC-1 liquid (mixed solution of ammonium hydroxide, hydrogen peroxide water, and pure water), SC-2 liquid (mixed solution of hydrochloric acid, hydrogen peroxide water, and pure water), hydrofluoric acid, or the like is used.

The processing unit 52 includes a processing chamber 60, a rotation holder 61, and a processing liquid nozzle 65. The processing chamber 60 is a hollow housing. The rotation holder 61, the processing liquid nozzle 65, and the like are provided inside the processing chamber 60. The processing chamber 60 is provided with a loading entrance (not illustrated). The loading entrance is opened and closed by a shutter. In a state where the loading entrance is open, the substrate W is loaded and unloaded with respect to the processing chamber 60 by the main conveyance robot. The loading entrance is closed during the processing of the substrate W.

The rotation holder 61 includes a spin chuck 62 and a spin motor 63. The spin chuck 62 is a substrate holder that holds the substrate W in a horizontal orientation (an orientation in which a normal line of the main surface of the substrate W comes along a vertical direction). The spin chuck 62 is, for example, a vacuum suction type chuck. The spin chuck 62 has a disk shape having a diameter smaller than the diameter of the substrate W. The spin chuck 62 sucks and holds the central part of the lower surface of the substrate W. In a state where the lower surface of the substrate W is sucked and held by the spin chuck 62, the peripheral edge portion of the substrate W protrudes outward from the outer peripheral end of the spin chuck 62. The spin chuck 62 may be a chuck of another form such as a pinching type mechanical chuck.

The spin chuck 62 is coupled to the spin motor 63 via a motor shaft. That is, the upper end of the motor shaft of the spin motor 63 is connected to the central part of the lower surface of the spin chuck 62. When the spin motor 63 rotates the motor shaft in a state where the substrate W is sucked and held by the spin chuck 62, the substrate W and the spin chuck 62 rotate in a horizontal plane around a rotation axis along a vertical direction.

A cup 64 is provided so as to surround the periphery of the spin chuck 62. The cup 64 can be lifted and lowered by a lifting mechanism (not illustrated). The cup 64 has a cylindrical shape, and an upper portion of the cup 64 is inclined so as to approach the spin chuck 62 as it goes upward. However, the inner diameter of the upper end portion of the cup 64 is larger than the diameter of the substrate W. At the time of processing the substrate W, the upper end of the cup 64 is higher than the height position of the substrate W held by the spin chuck 62. Thus, the liquid scattered by the centrifugal force from the substrate W rotated by the spin motor 63 is received and collected by the cup 64. The cup 64 may have a multistage structure in which a plurality of collection ports are provided for each purpose.

The processing liquid nozzle 65 includes a nozzle tip portion 66, a swing arm 67, and a swing motor 68. The processing liquid nozzle 65 is, for example, a straight nozzle that discharges the processing liquid in a continuous flow state. The nozzle tip portion 66 is attached to the tip of the swing arm 67 extending in a substantially horizontal direction. A discharge port (not illustrated) is formed at the lower end of the nozzle tip portion 66, and the processing liquid is discharged from the discharge port. The swing arm 67 is swung in a horizontal plane around an axis along the vertical direction by the swing motor 68. The swing motor 68 is, for example, a pulse motor.

When the swing motor 68 swings the swing arm 67, the nozzle tip portion 66 moves in an arc path between a processing position above the substrate W held by the rotation holder 61 and a standby position outside the cup 64. When the nozzle tip portion 66 is located at the processing position, the processing liquid nozzle 65 discharges the chemical liquid to the substrate W held by the rotation holder 61, and thus, for example, the cleaning processing on the substrate W proceeds. When the processing liquid nozzle 65 discharges pure water to the substrate W, the pure water rinsing processing on the substrate W proceeds. An encoder for detecting the position of the nozzle tip portion 66 may be attached to the swing motor 68.

In addition, the processing unit 52 includes a gas supply unit 110, an exhaust unit 120, a drain unit 130, and a processing liquid supply unit 150. The gas supply unit 110 supplies processing gas into the processing chamber 60. The gas supply unit 110 includes a nitrogen supply source 111, a gas supply valve 112, and a pipe 113. The tip side of the pipe 113 is connected to a fan filter unit (FFU) 69 provided on the ceiling portion of the processing chamber 60, and the base end side is connected to the nitrogen supply source 111. The FFU 69 includes a fan that generates a gas flow and a filter (for example, HEPA or ULPA filter) that collects and removes particles mixed in the gas flow. The gas supply valve 112 is provided in the middle of the path of the pipe 113. When the gas supply valve 112 is opened, nitrogen gas (N₂) is supplied from the nitrogen supply source 111 to the FFU 69 through the pipe 113, and the nitrogen gas is supplied from the FFU 69 into the processing chamber 60. The FFU 69 forms a downflow of gas into the processing chamber 60 from top to bottom.

The exhaust unit 120 discharges an atmosphere from the inside of the processing chamber 60. The exhaust unit 120 includes an exhaust apparatus 121, an exhaust valve 122, and a pipe 123. The tip side of the pipe 123 is connected to an exhaust duct 125 provided in the processing chamber 60, and the base end side is connected to the exhaust apparatus 121. The exhaust apparatus 121 includes, for example, a vacuum pump. The exhaust valve 122 is provided in the middle of the path of the pipe 123. When the exhaust valve 122 is opened while the exhaust apparatus 121 is operated, the gas in the processing chamber 60 is discharged from the exhaust duct 125.

The drain unit 130 discharges the used liquid collected by the cup 64 to the outside of the processing chamber 60. The drain unit 130 includes a drain processing apparatus 131, a drain valve 132, and a pipe 133. The tip side of the pipe 133 is connected to the bottom portion of the cup 64, and the base end side is connected to the drain processing apparatus 131. The drain valve 132 is provided in the middle of the path of the pipe 133. When the drain valve 132 is opened, the liquid collected by the cup 64 flows through the pipe 133 and is discharged to the drain processing apparatus 131.

The processing liquid supply unit 150 supplies the processing liquid to the processing liquid nozzle 65. The processing liquid supply unit 150 includes a pure water supply source 151, a pure water valve 152, a chemical liquid supply source 153, a chemical liquid valve 154, a filter 158, and a pipe 155. The tip side of the pipe 155 is connected to the nozzle tip portion 66 of the processing liquid nozzle 65, and the base end side is branched into two branches, one of which is connected to the pure water supply source 151 and the other is connected to the chemical liquid supply source 153. Of the two branch pipes branched from the pipe 155, one side connected to the pure water supply source 151 is provided with the pure water valve 152, and the other side connected to the chemical liquid supply source 153 is provided with the chemical liquid valve 154. The pipe 155 is provided with the filter 158. When the pure water valve 152 is opened, pure water is discharged from the processing liquid nozzle 65. When the chemical liquid valve 154 is opened, the chemical liquid is discharged from the processing liquid nozzle 65. Further, by opening both the chemical liquid valve 154 and the pure water valve 152, the chemical liquid diluted with pure water can be discharged from the processing liquid nozzle 65. The filter 158 removes impurities from the processing liquid flowing in the pipe 155. The filter 158 and the pipe 155 may be contained together in a fluid box attached to the processing chamber 60.

The processing chamber 60 of the processing unit 52 is provided with an inner cover 92 and an outer cover 95. The inner cover 92 is a transparent plate-like member such as an acrylic plate. The inner cover 92 is provided to face the internal space of the processing chamber 60. On the other hand, the outer cover 95 is an opaque plate-like member made of metal such as stainless steel. The outer cover 95 is provided outside the inner cover 92 so as to cover the inner cover 92.

Both the inner cover 92 and the outer cover 95 are provided to be openable and closable. When both the inner cover 92 and the outer cover 95 are closed, the operator cannot visually recognize the inside of the processing chamber 60. When the outer cover 95 is opened and only the inner cover 92 is closed, the operator can visually recognize the inside of the processing chamber 60 through the transparent inner cover 92. When both the outer cover 95 and the inner cover 92 are open, the inside of the processing chamber 60 is opened, and the operator can perform work on the spin chuck 62 and the processing liquid nozzle 65 inside the processing chamber 60.

The operator who performs work such as maintenance and inspection on the plurality of substrate processing apparatuses 50 disposed in the clean room 40 wears the smart glasses 10. The smart glasses 10 are a type of wearable terminal of a head mounted display (HMD) type. The smart glasses 10 are also a device for realizing augmented reality (AR) or mixed reality (MR). As the smart glasses 10, for example, "HoloLens" (registered trademark) manufactured by Microsoft Corporation can be used.

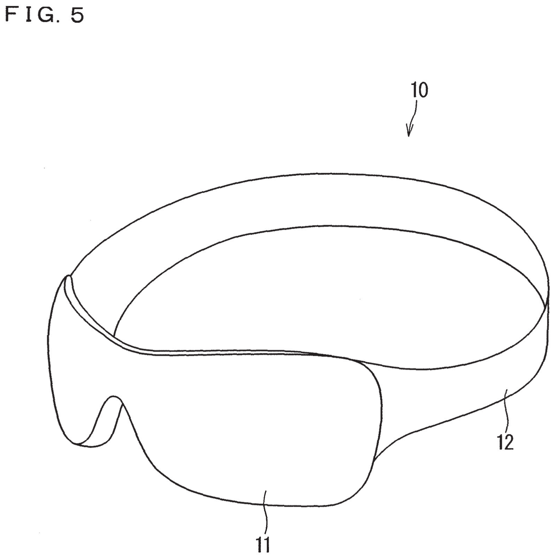

FIG. 5 is a perspective view illustrating an appearance of the smart glasses 10. The smart glasses 10 include a visor 11 and a headband 12. The operator wears the smart glasses 10 by attaching the headband 12 to the head. The operator can adjust the length of the headband 12 in accordance with the size of his or her head. The headband 12 is provided with a power button, a brightness button, a volume button, and the like.

The visor 11 includes various sensors and a display. The display is a see-through holographic lens. That is, the display can display a stereoscopic image in the visual field space of the operator with a hologram, and can transmit light from a real object like a normal spectacle lens. Thus, the operator wearing the smart glasses 10 can also view the displayed stereoscopic image while visually recognizing a real object through the display.

The sensor of the visor 11 includes, for example, a plurality of visible light cameras that mainly image the front of the visor 11, an infrared camera that tracks the line of sight of the operator, a depth sensor that measures the distance to an object, and an inertial measurement sensor. The infrared camera measures the movement of the eyeballs of the wearer of the smart glasses 10 to track the line of sight. The depth sensor measures the distance to an object by, for example, a time of flight (ToF) method. The inertial measurement sensor is composed of an accelerometer, a gyroscope, a magnetometer, and the like.

The smart glasses 10 incorporate a computer including a CPU and a memory. The smart glasses 10 are also provided with a wireless communication mechanism, and the computer of the smart glasses 10 is connected to the information communication network 5 using the wireless communication mechanism. Further, the smart glasses 10 are also provided with a microphone, a speaker, a battery, and the like.

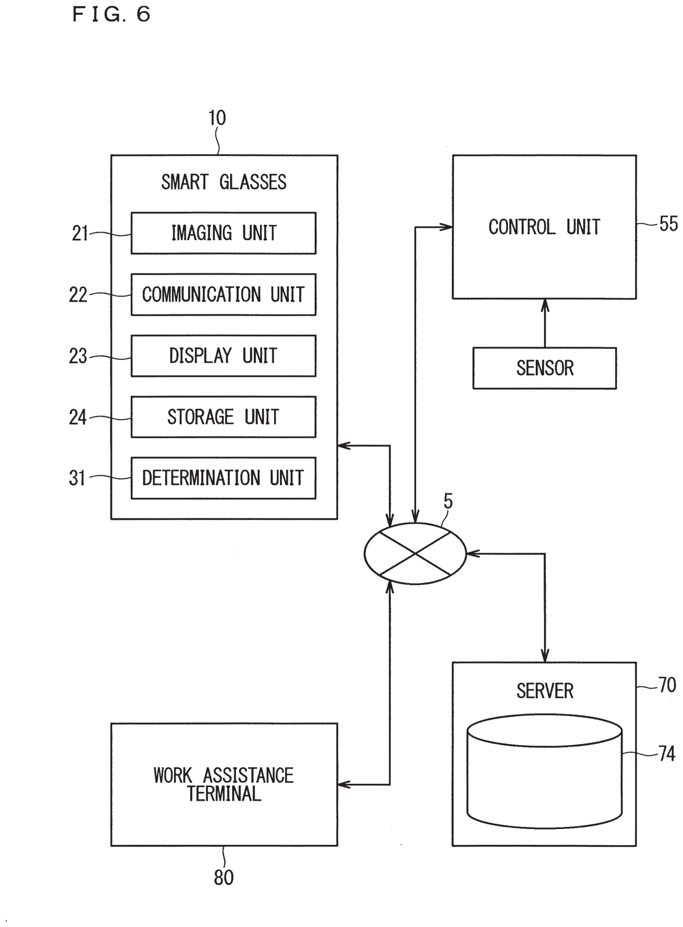

FIG. 6 is a block diagram illustrating functional configurations of the smart glasses 10, the server 70, the work assistance terminal 80, and the control unit 55 of the substrate processing apparatus 50. The smart glasses 10 include an imaging unit 21, a communication unit 22, a display unit 23, and a storage unit 24. The imaging unit 21 includes a visible light camera provided in the visor 11 described above. The imaging unit 21 includes, for example, four visible light cameras that image the front and oblique front, which can image the visual field range of the operator wearing the smart glasses 10.

The communication unit 22 includes the wireless communication mechanism of the smart glasses 10 described above. The communication unit 22 transmits and receives data to and from the work assistance terminal 80 and the server 70 via the information communication network 5. The communication unit 22 can directly transmit and receive data to and from the control unit 55 of the substrate processing apparatus 50 in a short distance. That is, the communication unit 22 can transmit data and commands to the control unit 55 of the substrate processing apparatus 50 directly or via the information communication network 5.

The display unit 23 includes the display of the visor 11 described above. The display unit 23 includes a holographic processing apparatus, and displays a stereoscopic image at a predetermined spatial position with a hologram technology. The stereoscopic image displayed by the display unit 23 is not limited to a three-dimensional image but may be a two-dimensional image such as a document.

The storage unit 24 includes a memory and a storage mounted on the smart glasses 10. The memory and the storage included in the smart glasses 10 are, for example, a dynamic random access memory (DRAM) and a universal flash storage (UFS), respectively. The storage unit 24 stores applications and data to be used by the computer of the smart glasses 10.

In addition, the smart glasses 10 include a determination unit 31. The determination unit 31 is a functional processing unit to be implemented by the CPU of the smart glasses 10 executing a predetermined processing program. The processing content of the determination unit 31 will be further described later.

The control unit 55 of the substrate processing apparatus 50 controls the operation of various mechanisms provided in the processing unit 52 such as the processing liquid nozzle 65. The control unit 55 of the substrate processing apparatus 50 can communicate with the communication unit 22 of the smart glasses 10 and can also control the operation of various mechanisms provided in the processing unit 52 according to a command of an operation instruction transmitted from the smart glasses 10.

The detection signals from a large number of sensors provided in the substrate processing apparatus 50 are transmitted to the control unit 55. The sensors provided in the substrate processing apparatus 50 include, for example, a chemical liquid concentration meter and a sensor that detects opening and closing of each valve.

The work assistance terminal 80 and the server 70 are installed, for example, in a factory of a vendor who manufactures and inspects the substrate processing apparatus 50. The work assistance terminal 80 and the server 70 can communicate with the smart glasses 10 via the information communication network 5. The work assistance terminal 80 and the server 70 can communicate with each other via the information communication network 5.

The work assistance terminal 80 and the server 70 are general computer systems. That is, the work assistance terminal 80 and the server 70 include a CPU as a circuit that performs various arithmetic processing, a ROM as a read-only memory that stores a basic program, a RAM as a readable and writable memory that stores various types of information, a storage unit (for example, a magnetic disk or SSD) that stores control software, data, and the like, and a communication unit that communicates with the information communication network 5.

The work assistance terminal 80 is, for example, a computer for a work assistant on the vendor side to support the work of the operator in the clean room 40. The work assistant can transmit various types of information from the work assistance terminal 80 to the smart glasses 10 worn by the operator in the clean room 40.

In the work assistance system according to the present invention, the server 70 is a computer that executes predetermined processing in response to requests from the smart glasses 10 and the work assistance terminal 80. The server 70 includes a storage unit 74 having a relatively large capacity. The large-sized data created by the smart glasses 10 and the work assistance terminal 80 may be stored in the storage unit 74. The server 70 is not an essential element.

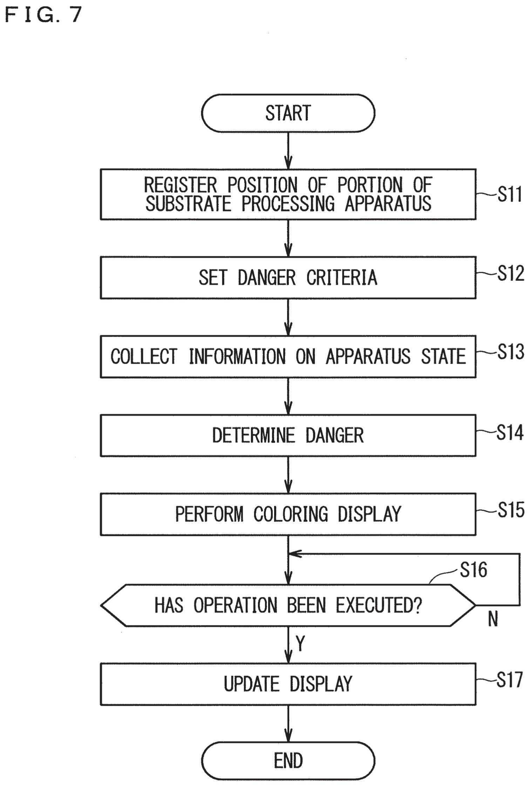

Next, a work assistance method using the work assistance system having the above-described configuration will be described. FIG. 7 is a flowchart illustrating a procedure of a work assistance method according to the present invention. Of the steps illustrated in FIG. 7, step S11 and step S12 are preliminary preparation processing.

First, positions of portions included in the substrate processing apparatus 50 are registered (step S11). This processing is performed using a visual positioning system (VPS) function of the smart glasses 10.

In the following description, there may be a description that the operator performs an operation such as selection or input using the stereoscopic image displayed by the display unit 23 of the smart glasses 10. This means that when the operator performs an operation such as selection or input with respect to the stereoscopic image displayed by the display unit 23 by a hand gesture, the imaging unit 21 images and detects the hand gesture, and the computer of the smart glasses 10 recognizes that a predetermined operation has been performed from the detection result. Alternatively, when the operator performs an operation such as selection or input with respect to the stereoscopic image displayed by the display unit 23 by a movement of the line of sight, the smart glasses 10 may track and detect the line of sight with an eye tracking function to recognize that a predetermined operation has been performed.

As preliminary preparation processing, a part of the inside of the clean room 40 is scanned with the smart glasses 10 to form a spatial mesh. This processing is performed, for example, by an operator wearing the smart glasses 10 in the clean room 40 using the smart glasses 10.

The operator turns on a scan mode preset in the smart glasses 10. For example, the operator can select and turn on the scan mode by a hand gesture from a menu screen displayed as a stereoscopic image by the display unit 23. The gesture of the hand is imaged and detected by the imaging unit 21, and the computer of the smart glasses 10 recognizes that the scan mode is selected from the detection result. Alternatively, the operator may turn on the scan mode by pressing a predetermined button provided on the smart glasses 10.

When the scan mode is turned on, the smart glasses 10 scan a space including the substrate processing apparatus 50 in the clean room 40 with the depth sensor to create a spatial mesh. The display unit 23 superimposes and displays a mesh graphic on the visual field space of the operator seen through the visor 11.

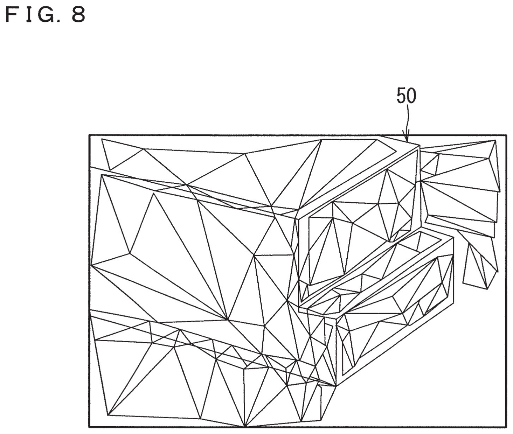

FIG. 8 is a diagram illustrating an example of the spatial mesh. As illustrated in the figure, the spatial mesh created by the smart glasses 10 is represented by a number of triangular meshes. Various shapes including a curved surface and a flat surface are represented by a coupled set of a large number of triangles. A complex shape including irregularities is represented by high-density triangles, and conversely, a flat shape is represented by relatively low-density triangles. As illustrated in FIG. 8, the spatial mesh created by scanning a space including the substrate processing apparatus 50 with the smart glasses 10 is displayed to be superimposed on the actual substrate processing apparatus 50.

Even in a case where a plurality of substrate processing apparatuses 50 of the same type and the same form (that is, in the same appearance) are disposed in the clean room 40, the spatial meshes created due to subtle differences (for example, a difference in the situation of the passage) around each substrate processing apparatus 50 are different when a space including the plurality of substrate processing apparatuses 50 is scanned to create a spatial mesh. Thus, the smart glasses 10 can distinguish the plurality of substrate processing apparatuses 50 disposed in the clean room 40 by the difference in the spatial mesh.

The operator scans a space including the substrate processing apparatus 50 with the smart glasses 10 to create a spatial mesh, and then installs a virtual object on the displayed spatial mesh. The virtual object is a virtual marker displayed as a stereoscopic image by the display unit 23. For example, the operator places the virtual object at any position around the substrate processing apparatus 50 by a hand gesture (for example, by pinching with a hand,) in an image in which the spatial mesh as illustrated in FIG. 8 is displayed. Further, thereafter, the operator may finely adjust the position of the virtual object using a remote controller screen displayed as the stereoscopic image by the display unit 23. The installation position of the virtual object may overlap with the substrate processing apparatus 50.

When the virtual object is installed on the spatial mesh of the substrate processing apparatus 50, the smart glasses 10 set the position of the virtual object as a reference position with respect to the substrate processing apparatus 50. In addition, by installing the virtual object on the spatial mesh, the smart glasses 10 recognize the position of the virtual object itself using the feature portion of the spatial mesh. The feature portion of the spatial mesh is, for example, a portion having a characteristic mesh form at the time of scanning, such as a corner portion of the substrate processing apparatus 50.

Next, the position of the portion of the substrate processing apparatus 50 is calculated and registered based on the reference position set by installing the virtual object. For example, the operator superimposes a CAD diagram of the substrate processing apparatus 50 on the region of the substrate processing apparatus 50 visible from the visor 11. At this time, a 3D CAD diagram is preferably superimposed on the substrate processing apparatus 50. The CAD diagram of the substrate processing apparatus 50 is created in advance at the apparatus design stage, and the data thereof is stored in the storage unit 74 of the server 70, for example. The smart glasses 10 read the data of the CAD diagram of the substrate processing apparatus 50 from the server 70, and the display unit 23 displays the CAD diagram. The operator moves the displayed CAD diagram by a hand gesture to superimpose the CAD diagram on the substrate processing apparatus 50. Also at this time, the operator may finely adjust the position of the CAD diagram using the remote controller screen displayed as the stereoscopic image by the display unit 23.

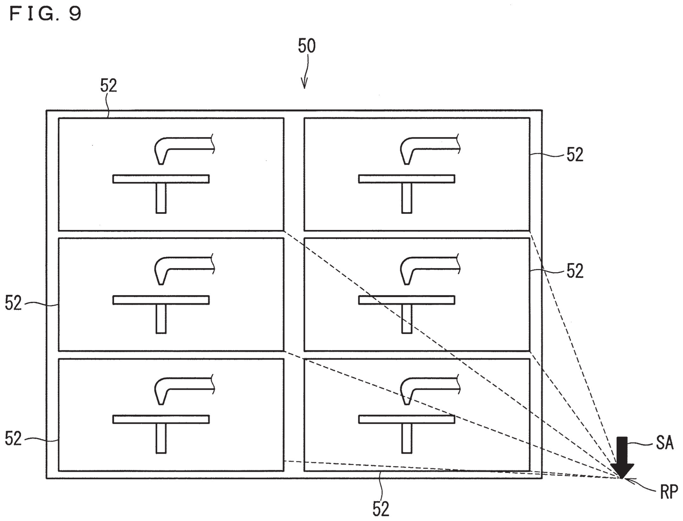

By accurately superimposing the CAD diagram of the substrate processing apparatus 50 on the region of the substrate processing apparatus 50 visible from the visor 11, the smart glasses 10 calculate and register the relative positional relationship between the reference position (the position of the virtual object) and the portion included in the substrate processing apparatus 50. FIG. 9 is a diagram schematically illustrating a relative positional relationship between the reference position and a portion of the substrate processing apparatus 50. When a virtual object SA is installed, the position is registered as a reference position RP. The position of the portion included in the substrate processing apparatus 50 can be obtained from coordinate information included in the CAD data. The smart glasses 10 calculate and register a relative positional relationship between the reference position RP and any portion (for example, a corner of the substrate processing apparatus 50) of the substrate processing apparatus 50 based on the position information of the reference position RP and the coordinate information of the data of the CAD diagram superimposed on the substrate processing apparatus 50.

The data of the CAD diagram also includes coordinate information of the processing unit 52 provided in the substrate processing apparatus 50 and a portion (for example, the spin chuck 62 and the processing liquid nozzle 65) provided in the processing unit 52. Thus, the smart glasses 10 calculate and register a relative positional relationship between each of the plurality of processing units 52 mounted on the substrate processing apparatus 50 and the reference position RP. Further, the smart glasses 10 calculate and register a relative positional relationship between a portion provided in each processing unit 52 and the reference position RP. Regarding the drive portion such as the processing liquid nozzle 65, the coordinate information included in the data of the CAD diagram is for the home position. Thus, the relative positional relationship between the drive portion located at the home position (the above-described standby position in the case of the processing liquid nozzle 65) and the reference position RP is calculated.

The smart glasses 10 may register the position of the portion by, for example, writing a calculated relative positional relationship between the reference position RP and the portion of the substrate processing apparatus 50 in a position table. Specifically, the smart glasses 10 register the name of the virtual object, the apparatus portion of the substrate processing apparatus 50 associated therewith, the relative position information of the apparatus portion, and the like in the position table in association with each other.

The smart glasses 10 do not need to calculate or register the relative positional relationship for all the portions included in the substrate processing apparatus 50 as long as the relative positional relationship for necessary portions is calculated. The portion included in the substrate processing apparatus 50 includes a representative point of the entire substrate processing apparatus 50, a plurality of processing units 52 mounted on the substrate processing apparatus 50, and various mechanisms provided in each processing unit 52. For example, the smart glasses 10 may calculate and register a relative positional relationship of only the processing liquid nozzle 65 of the substrate processing apparatus 50 with respect to the reference position RP. That is, the smart glasses 10 may calculate and register a relative positional relationship between at least one portion included in the substrate processing apparatus 50 and the reference position RP.

Next, as preliminary preparation processing different from position registration, danger criteria are set (step S12). Specifically, an apparatus state serving as a reference for determining as dangerous is set. For example, a concentration of the vapor of the chemical liquid in the processing chamber 60, which is determined to be dangerous when it is equal to or higher than the concentration, is set. Alternatively, an open or close state of each valve to be determined to be dangerous is set. This work may be performed by the operator using the smart glasses 10, or may be performed by the work assistant from the work assistance terminal 80.

Step S13 and subsequent steps in FIG. 7 are post-processing when the operator performs maintenance work on any of the substrate processing apparatuses 50. Maintenance is performed on these substrate processing apparatuses 50 regularly or irregularly. Typically, the maintenance is performed irregularly when some trouble occurs in the substrate processing apparatus 50. In the present embodiment, the operator wears the smart glasses 10 to perform maintenance work.

First, state information regarding an apparatus state of the substrate processing apparatus 50 is collected (step S13). Specifically, the substrate processing apparatus 50 is provided with a large number of sensors, and the control unit 55 collects state information from each sensor. For example, the control unit 55 acquires the oxygen concentration and the concentration of the vapor of the chemical liquid (for example, the concentration of hydrogen fluoride) in the processing chamber 60 from the concentration meter. In addition, the control unit 55 acquires the chemical liquid concentration in the processing liquid remaining in the processing liquid nozzle 65 from a concentration meter different from the concentration meter. Further, the control unit 55 acquires information regarding opening and closing of each valve, for example, information indicating that the pure water valve 152 remains closed after the chemical liquid valve 154 is opened. The state information collected by the control unit 55 is accumulated in, for example, a storage unit included in the control unit 55. The control unit 55 may collect information from a motion history or a work history (work log) in addition to the information from the sensor.

Next, based on the state information collected in step S13, the determination unit 31 of the smart glasses 10 performs danger determination for each portion in the substrate processing apparatus 50 (step S14). The target portion to be determined in step S14 includes any space in the processing chamber 60. The determination unit 31 performs danger determination in the substrate processing apparatus 50 based on the state information, and determines whether operation with respect to each portion is possible. For example, when the concentration of the vapor of the chemical liquid in the processing chamber 60 collected in step S13 is equal to or more than the reference value set in step S12, the determination unit 31 determines that the inside of the processing chamber 60 is in a dangerous state and determines that the inner cover 92 exposed to the internal space of the processing chamber 60 cannot be opened. On the other hand, the determination unit 31 determines that the outer cover 95 not in direct contact with the internal space of the processing chamber 60 can be opened. In addition, for example, also when the pure water valve 152 remains closed after the chemical liquid valve 154 is opened, the chemical liquid remains attached to the inner surface of the cup 64 in the processing chamber 60, and thus the determination unit 31 performs the same determination as described above. Further, for example, when the residual pressure in the pipe 155 is equal to or more than the reference value, the determination unit 31 determines that the pipe 155 is in a dangerous state and determines that the filter 158 cannot be operated. To execute such determination as to whether the operation is possible, it is preferable to set whether the operation with respect to each portion is possible based on the apparatus state in step S12. More specifically, for example, a table may be created in which the apparatus state is associated with whether the operation with respect to each portion is possible.

Next, when the operator wearing the smart glasses 10 approaches the substrate processing apparatus 50, for example, for maintenance work, the display unit 23 performs coloring display with respect to the portion (visually recognizable portion) that can be seen by the operator among the portions determined whether the operation is possible in step S14 (step S15). For example, when both the inner cover 92 and the outer cover 95 are closed, the operator can see the outer cover 95, but cannot see the inside of the inner cover 92 or the inside of the processing chamber 60. That is, the outer cover 95 is a visually recognizable portion. In this case, the display unit 23 of the smart glasses 10 performs coloring display with respect to the outer cover 95, but does not perform coloring display with respect to the inner cover 92 or portions inside the processing chamber 60.

More specifically, the smart glasses 10 specify the position of the visually recognizable portion for which the danger determination has been made based on the position information of the portion registered in step S11. Then, the display unit 23 of the smart glasses 10 may perform coloring display with respect to the specified position. In the present embodiment, the display unit 23 may color, for example, the outer surface of the outer cover 95 in a planar (two-dimensional) manner.

In addition, the display unit 23 performs coloring display with a first display color on a portion determined to be inoperable. For example, when the outer cover 95 cannot be opened, the display unit 23 performs coloring display in the first display color (for example, red) with respect to the outer cover 95. On the other hand, the display unit 23 performs coloring display in a second display color different from the first display color with respect to the portion determined to be operable. For example, when the outer cover 95 is openable, the display unit 23 performs coloring display in the second display color (for example, blue) with respect to the outer cover 95.

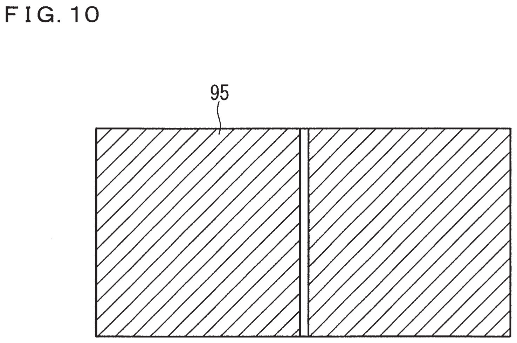

FIG. 10 is a diagram illustrating an example of coloring display on the outer cover 95. In the example described above, the concentration of the vapor of the chemical liquid in the processing chamber 60 is equal to or higher than the reference value, the inside of the processing chamber 60 is determined to be in a dangerous state, and it is determined that the opening of the inner cover 92 is not possible while the opening of the outer cover 95 is possible. In this case, the display unit 23 of the smart glasses 10 performs coloring display in the second display color (blue) with respect to the outer cover 95.

By performing the coloring display with respect to the portion that can be seen by the operator in this manner, the operator can easily recognize whether the portion can be operated. In the example described above, by performing coloring display on the outer cover 95 that can be visually recognized by the operator, the operator can easily recognize whether the operator can open the outer cover 95.

On the other hand, it is not displayed whether the operator can operate the portion that cannot be directly seen from the operator (for example, the inner cover 92 and the inside of the processing chamber 60). In the example described above, the fact that the inner cover 92 cannot be opened is not displayed. That is, coloring display is performed with respect to only the outer cover 95, and nothing is displayed regarding the inner cover 92. Thus, regardless of the situation of the portion that cannot be seen, the operator can clearly recognize whether the visually recognizable portion can be operated. In the example described above, the operator can clearly recognize that the outer cover 95 can be opened for the time being regardless of the conditions of the inside of the processing chamber 60 and the inner cover 92.

Next, the operator who has seen the result of the coloring display with respect to the visually recognizable portion may execute an operation with respect to the visually recognizable portion (step S16). For example, the operator who has seen that the outer cover 95 is colored and displayed in the second display color (blue) may open the outer cover 95.

When such an operation is executed, the processing proceeds from step S16 to step S17, and the display unit 23 updates the display. Specifically, the display unit 23 performs coloring display with respect to a portion that is newly visible to the operator as a result of execution of the operation. In the example described above, the display unit 23 performs coloring display with respect to the inside of the processing chamber 60 and the inner cover 92 that are newly visible to the operator as a result of the opening of the outer cover 95.

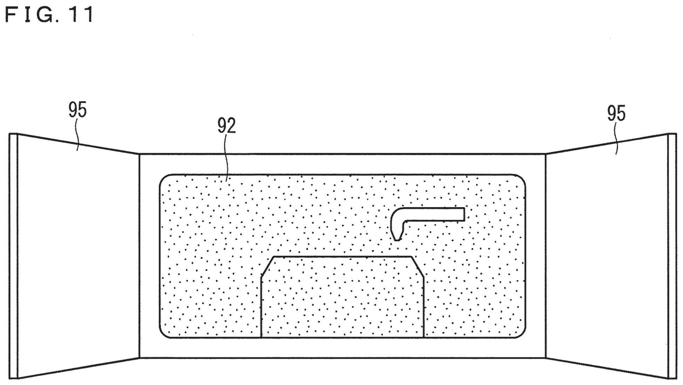

FIG. 11 is a diagram illustrating an example of coloring display with respect to the inner cover 92 when the outer cover 95 is opened. In the example described above, the concentration of the vapor of the chemical liquid in the processing chamber 60 is equal to or higher than the reference value, the inside of the processing chamber 60 is determined to be in a dangerous state, and the opening of the inner cover 92 is determined to be impossible. Thus, the display unit 23 of the smart glasses 10 performs coloring display with respect to the inner cover 92 and the inside of the processing chamber 60 in the first display color (red).

When the operator opens the outer cover 95 displayed in blue, the operator sees the inner cover 92 displayed in red. That is, the operator can check the state of the inner cover 92 for the first time by opening the outer cover 95. The operator can easily recognize that the inner cover 92 cannot be opened by seeing the inner cover 92 displayed in red. As a result, it is possible to prevent the operator from being exposed to danger by opening the inner cover 92.

In the present embodiment, it is determined whether a portion in the apparatus can be operated based on the collected state information, and the coloring display based on the determination result is performed with respect to the portion (visually recognizable portion) that the operator can see among the determined portions. On the other hand, the portion that cannot be seen by the operator is not displayed. Thus, the operator can easily and clearly recognize whether the portion to be worked can be operated regardless of the situation of the portion that cannot be seen.

Although the embodiment of the present invention has been described above, various modifications other than those described above can be made without departing from the gist of the present invention. For example, in the embodiment described above, the coloring display is performed with respect to the visually recognizable portion visible to the operator, but the present invention is not limited to this configuration. Annotation display indicating whether the operator can perform the operation may be performed. As such annotation display, for example, the display unit 23 of the smart glasses 10 may display a message (for example, "cover cannot be opened"). Alternatively, a sound may be emitted from a speaker of the smart glasses 10 to notify the operator.

In the embodiment described above, the danger determination is performed by the determination unit 31 provided in the smart glasses 10, but the present invention is not limited to this configuration. The danger determination may be performed by the work assistance terminal 80 or the server 70. Alternatively, the control unit 55 of the substrate processing apparatus 50 may perform danger determination in the substrate processing apparatus 50.

Further, "Normal" or "Maintenance" may be made selectable with pull-down menu displayed as a stereoscopic image by the display unit 23 of the smart glasses 10, for example. When "Normal" is selected, the smart glasses 10 do not perform coloring display. It is possible to prevent the smart glasses 10 from performing coloring display when there is no need. On the other hand, when "Maintenance" is selected, the smart glasses 10 may perform coloring display as in the embodiment described above.

In the embodiment described above, the operator uses the smart glasses 10, but the present invention is not limited to this configuration. A mobile terminal such as a tablet terminal or a smartphone may be used instead of the smart glasses 10. That is, a mobile terminal including a display unit and a communication unit is used. When a tablet terminal or the like is used, a hand of the operator holding the tablet terminal is blocked, and thus, it is preferable to use a wearable terminal such as the smart glasses 10.

The substrate processing apparatus 50 is not limited to a substrate cleaning apparatus. It may be any apparatus that performs predetermined processing on a substrate, such as a heat treatment apparatus, an exposure apparatus, a coating and development apparatus, a measurement apparatus, or an inspection apparatus. When the substrate processing apparatus 50 is a substrate cleaning apparatus, it may be a single wafer type cleaning apparatus that cleans substrates one by one, or may be a batch type cleaning apparatus that collectively cleans a plurality of substrates. The operation assistance technology according to the present invention is suitable for a liquid processing apparatus such as a substrate cleaning apparatus in which an invisible dangerous state is likely to occur due to the use of a chemical liquid. In the embodiment described above, nitrogen gas is exemplified as the processing gas supplied by the gas supply unit 110 to form a down flow in the processing chamber 60 to obtain a low oxygen atmosphere, but a processing gas different from the nitrogen gas may be supplied from a shielding plate or another gas nozzle to set the vicinity of the substrate W to a specific atmosphere involved in the processing. Examples of such processing gas include oxygen (O₂), ozone (O₃), and ammonia (NH₃).

When the substrate processing apparatus 50 is a UV irradiation apparatus that irradiates the substrate with ultraviolet rays to decompose and remove organic substances and the like, the inside of the processing chamber is in a dangerous state when the substrate is irradiated with ultraviolet rays from the UV lamp. In the embodiment described above, the cause of the dangerous state in the processing chamber is the atmosphere of the chemical liquid. Thus, it has been determined that the opening of the inner cover 92 is not possible but the opening of the outer cover 95 is possible. In the UV irradiation apparatus, even though the outer cover is opened, the ultraviolet ray is transmitted through the transparent inner cover and emitted to the outside of the apparatus, which is dangerous. Thus, it is determined that the outer cover cannot be opened. Thus, the display unit 23 of the smart glasses 10 also performs coloring display in the first display color (red) with respect to the outer cover.

Further, the target of the work assistance technology according to the present invention is not limited to the substrate processing apparatus, but may be any industrial equipment that can cause some invisible dangerous state. Examples of such industrial equipment include a printing processing apparatus, a film forming apparatus, a medical apparatus, and an appearance inspection apparatus.

### EXPLANATION OF REFERENCE SIGNS

5: information communication network
10: smart glasses
21: imaging unit
22: communication unit
23: display unit
24, 74: storage unit
31: determination unit
50: substrate processing apparatus
52: processing unit
61: rotation holder
62: spin chuck
65: processing liquid nozzle
66: nozzle tip portion
70: server
80: work assistance terminal
92: inner cover
95: outer cover
110: gas supply unit
120: exhaust unit
130: drain unit
150: processing liquid supply unit
W: substrate

## Claims

1. A work assistance method used when predetermined work is performed on industrial equipment, the work assistance method comprising:
an information acquisition step of collecting state information regarding an apparatus state of said industrial equipment;
a determination step of determining whether operation with respect to a visually recognizable portion of said industrial equipment is possible based on said state information; and
a display step of performing annotation display with respect to said visually recognizable portion based on a determination result in said determination step with a mobile terminal including a display unit and a communication unit.

2. The work assistance method according to claim 1, wherein
in said display step, said mobile terminal performs coloring display in a first display color with respect to said visually recognizable portion determined to be inoperable in said determination step.

3. The work assistance method according to claim 2, wherein
in said display step, said mobile terminal performs coloring display in a second display color with respect to said visually recognizable portion determined to be operable in said determination step.

4. The work assistance method according to claim 3, wherein
said industrial equipment is a substrate processing apparatus that performs predetermined processing on a substrate,
a processing chamber included in said substrate processing apparatus is provided with an inner cover and an outer cover, and
in said display step, when an inside of said processing chamber is in a dangerous state, coloring display is performed in said second display color with respect to said outer cover when said inner cover and said outer cover are closed, and coloring display is performed in said first display color with respect to said inner cover when said outer cover is opened.

5. The work assistance method according to claim 4, wherein
said substrate processing apparatus is a substrate cleaning apparatus that uses a processing gas and a processing liquid in said processing chamber.

6. The work assistance method according to any one of claims 1 to 5, wherein
said mobile terminal is smart glasses.

7. A work assistance system used when predetermined work is performed on industrial equipment, the work assistance system comprising:
a mobile terminal including a display unit and a communication unit; and
a determination unit that determines whether an operation with respect to a visually recognizable portion of said industrial equipment is possible based on state information regarding an apparatus state of said industrial equipment,
wherein said display unit performs annotation display with respect to said visually recognizable portion based on a determination result determined by said determination unit.

8. The work assistance system according to claim 7, wherein
said display unit performs coloring display in a first display color with respect to said visually recognizable portion determined to be inoperable by said determination unit.

9. The work assistance system according to claim 8, wherein
said display unit performs coloring display in a second display color with respect to said visually recognizable portion determined to be operable by said determination unit.

10. The work assistance system according to claim 9, wherein
said industrial equipment is a substrate processing apparatus that performs predetermined processing on a substrate,
a processing chamber included in said substrate processing apparatus is provided with an inner cover and an outer cover, and
when an inside of said processing chamber is in a dangerous state, said display unit performs coloring display in said second display color with respect to said outer cover when said inner cover and said outer cover are closed, and performs coloring display in said first display color with respect to said inner cover when said outer cover is opened.

11. The work assistance system according to claim 10, wherein
said substrate processing apparatus is a substrate cleaning apparatus that uses a processing gas and a processing liquid in said processing chamber.

12. The work assistance system according to any one of claims 7 to 11, wherein said mobile terminal is smart glasses.
